# EUROPEAN PATENT APPLICATION

(11) **EP 4 257 727 A1**
(43) Date of publication of application: **11.10.2023**
(21) Application number: 21903349.5
(22) Date of filing: 06.12.2021
(51) Int. Cl.: C23F 1/28, H01L 21/28, H01L 21/306, H01L 21/3213, H01L 21/768, H01L 21/3205, H01L 23/532

(54) **RECESS ETCHING SOLUTION, RECESS ETCHING METHOD, AND SURFACE-TREATED SEMICONDUCTOR SUBSTRATE MANUFACTURING METHOD**

(30) Priority: 07.12.2020 JP 2020202776
(71) Applicant: MITSUBISHI GAS CHEMICAL COMPANY, INC., Chiyoda-ku Tokyo 100-8324 (JP)
(72) Inventor: OKABE Satoshi, Tokyo 100-8324 (JP); OIE Toshiyuki, Taichung City, 435059 (TW); ADANIYA Tomoyuki, Tokyo 125-8601 (JP); HOMMO Yoshihiro, Taichung City, 435059 (TW); CHEN Chung-Yi, Taichung City, 435059 (TW); WANG Po-Hung, Taichung City, 435059 (TW)
(74) Representative: Müller-Boré & Partner Patentanwälte PartG mbB
(86) International application number: PCT/JP2021/044614
(87) International publication number: WO 2022/124246

(57) **Abstract**

The present invention relates to: a recess etching solution for applying recess etching to metal wiring in a semiconductor substrate manufacturing process; and a recess etching method employing the same. A recess etching solution according to the present invention is for applying recess etching to a surface of a cobalt-containing metal layer embedded in a via or a trench formed in a semiconductor substrate, and contains (A) an organic acid, one of or both of (B) a nitrogen-containing heterocyclic compound and (C) an organic solvent, and (D) water. In addition, a recess etching method according to the present invention includes a recess etching step for applying recess etching to a surface of a cobalt-containing metal layer by bringing the recess etching solution into contact with the surface of the cobalt-containing metal layer embedded in a via or a trench formed in a semiconductor substrate.

## Description

### TECHNICAL FIELD

The present invention relates to a recess etchant (recess etching solution), a recess etching method, a method for manufacturing a surface-treated semiconductor substrate, and a method for manufacturing a semiconductor device.

### BACKGROUND ART

In recent years, as electronic equipment becomes smaller, lighter, and more sophisticated, there is a strong demand for finer and denser metal wiring in semiconductor devices. Due to this demand for miniaturization and high density, a short circuit in the metal wiring caused by misalignment during formation of a metal wiring pattern is likely to occur when connecting the top and bottom conductive layers in the manufacture of a semiconductor substrate. This has led to the problem of lower yields in semiconductor device manufacturing lines, and the margin for permissible misalignment during formation of a metal wiring pattern has become narrower.

The Fully Self-Aligned Via (hereinafter also referred to as "FSAV") process has been proposed as a technique to improve this problem. One approach using the FSAV process is to perform recess etching in advance on the metal embedded in the lower conductive layer, i.e., a via or a trench.

Non-patent literature 1 discloses, as an example of recess etching using a chemical, that when a comparison was made between a method in which a treatment was performed on a cobalt metal layer in a single step using a mixture of hydrogen peroxide and either hydrofluoric acid or acetic acid and a method in which an oxidation treatment with hydrogen peroxide and an etching treatment with acetic acid were repeatedly performed on a cobalt metal layer, the latter method was more suitable in terms of the ease of controlling the amount of recess etching.

Patent literature 1 also describes a method in which an oxidation treatment of a metal layer on a substrate surface with an oxidizing fluid and an etching treatment of the oxidized metal layer with an etchant are repeatedly performed.

### CITATION LIST

### Patent Literature

Patent Literature 1: Japanese Unexamined Patent Application Publication No. 2019-61978

### Non-Patent Literature

Non-patent Literature 1: Y. Akanishi et al, ECS Transactions, 92 (2) 255-263 (2019)

### SUMMARY OF INVENTION

### Technical Problem

However, the methods of repeated oxidation and etching treatments proposed in Patent literature 1 and Non-patent literature 1 have problems such as long time is needed for recess etching or steps are complicated.

Further, in order to obtain highly reliable wiring that is resistant to electromigration or the like, the smoothness of the etched surface when recess etching is performed on a metal embedded in a via or a trench as the conductive layer, is important.

Under these circumstances, it is desirable to provide a recess etchant and a recess etching method using said etchant to perform recess etching on metal wiring more evenly in a shorter time.

### Solution to Problem

The present invention relates to a recess etchant, a recess etching method, a method for manufacturing a semiconductor substrate, and a method for manufacturing a semiconductor device as follows.
[1] A recess etchant for performing recess etching on a surface of a cobalt-containing metal layer embedded in a via or a trench formed in a semiconductor substrate, the recess etchant comprising the following components:
   (A) organic acid; either or both of (B) nitrogen-containing heterocyclic compound and (C) organic solvent; and (D) water.
[2] The recess etchant according to [1] above, comprising the following components: (A) organic acid; (B) nitrogen-containing heterocyclic compound; (C) organic solvent; and (D) water.
[3] The recess etchant according to either one of [1] and [2] above, wherein Component (A) above is one or more selected from the group consisting of aliphatic carboxylic acids with 1-12 carbon atoms and aromatic carboxylic acids with 6-16 carbon atoms.
[4] The recess etchant according to [3] above, wherein the aromatic carboxylic acid is one or more selected from the group consisting of benzoic acid, phthalic acid, isophthalic acid, terephthalic acid, 3-hydroxybenzoic acid, and 4-hydroxybenzoic acid.
[5] The recess etchant according to either one of [3] and [4] above, wherein the aliphatic carboxylic acid is one or more selected from the group consisting of acetic acid and citric acid.
[6] The recess etchant according to any one of [1] to [5] above, wherein Component (B) above is one or more selected from the group consisting of triazoles, tetrazoles, thiazoles, pyrazoles, imidazoles, and nucleobases.
[7] The recess etchant according to any one of [1] to [6] above, wherein Component (B) above is one or more selected from the group consisting of 1,2,3-triazole, 1,2,4-triazole, 3,5-dimethyl-1,2,4-triazole, 3-amino-1,2,4-triazole, 4-amino-1,2,4-triazole, 3-mercapto-4-methyl-4H-1,2,4-triazole, 1H-benzotriazole, 1H-benzotriazole-1-methanol, 4-methyl-1H-benzotriazole, 2-(2-hydroxy-5-methylphenyl)benzotriazole, 5-methyl-1H-benzotriazole, 3-chloro-1H-benzotriazole, 5-chloro-1H-benzotriazole, methyl 1,2,4-triazole-3-carboxylate, 2-(5-chloro-2-benzotriazolyl)-6-tert-butyl-p-cresol, and 3-amino-1H-triazole.
[8] The recess etchant according to any one of [1] to [7] above, wherein Component (C) above is one or more selected from the group consisting of organic solvents having an HLB (Hydrophile-Lipophile Balance) value of 3-15.
[9] The recess etchant according to any one of [1] to [8] above, wherein Component (C) above is one or more selected from the group consisting of 1-propanol, 2-propanol, 1-butanol, 2-butanol, 2-methyl-1-propanol, 2-methyl-2-propanol, cyclohexanol, ethylene glycol, propylene glycol, 1,2-butanediol, 1,3-butanediol, 1,4-butanediol, 2,3-butanediol, 1,2-pentanediol, 1,5-pentanediol, 2,4-pentanediol, diethylene glycol, dipropylene glycol, dibutylene glycol, triethylene glycol, tripropylene glycol, 1,2-hexanediol, 1,6-hexanediol, neopentyl glycol, glycerol, dimethyl sulfoxide, dimethylformamide, dimethylacetamide, acetone, and methyl ethyl ketone.
[10] The recess etchant according to any one of [1] to [9] above, comprising 0.001-10 mass% of (A) organic acid, 0.001-5 mass% of (B) nitrogen-containing heterocyclic compound, and 1-99 mass% of (C) organic solvent.
[11] The recess etchant according to any one of [1] to [10] above, wherein the pH value is in the range from 1.0 to 6.0.
[12] A recess etching method comprising a recess etching step in which the recess etchant according to any one of [1] to [11] above is brought into contact with a surface of a cobalt-containing metal layer embedded in a via or a trench formed in a semiconductor substrate to perform recess etching on the surface of the cobalt-containing metal layer.
[13] A method for manufacturing a surface-treated semiconductor substrate, the method comprising a recess etching step in which the recess etchant according to any one of [1] to [11] above is brought into contact with a surface of a cobalt-containing metal layer embedded in a via or a trench formed in a semiconductor substrate to perform recess etching on the surface of the cobalt-containing metal layer.
[14] A method for manufacturing a semiconductor device, comprising:
   a recess etching step in which the recess etchant according to any one of [1] to [11] above is brought into contact with a surface of a cobalt-containing metal layer embedded in a via or a trench formed in a semiconductor substrate to perform recess etching on the surface of the cobalt-containing metal layer;
   a step of stacking a metal wiring layer on the surface of the cobalt-containing metal layer in the surface-treated semiconductor substrate obtained in the above step to obtain a semiconductor substrate having a wiring circuit constructed thereon; and
   a step of cutting the semiconductor substrate having the wiring circuit constructed thereon obtained in the above step into a predetermined shape, thereby obtaining a semiconductor device.

### ADVANTAGEOUS EFFECTS OF INVENTION

According to the present invention, recess etching can be performed on metal wiring including a cobalt-containing metal layer in a single step more efficiently in a shorter time. According to a preferred embodiment of the invention, the amount of recess etching can be controlled, and a more uniform and smoother recess-etched surface can be formed.

### BRIEF DESCRIPTION OF DRAWINGS

[Figure 1] Drawings for illustrating a recess etching method according to the present invention.
[Figure 2] A cross-sectional SEM image of an evaluation sample obtained in Example 11 after the etching treatment.

### DESCRIPTION OF EMBODIMENTS

### 1. Recess etchant

The recess etchant of the present invention is a recess etchant for performing recess etching on a surface of a cobalt-containing metal layer embedded in a via or a trench formed in a semiconductor substrate, where the recess etchant is characterized by comprising the following components:
(A) organic acid; either or both of (B) nitrogen-containing heterocyclic compound and (C) organic solvent; and (D) water.

Since the recess etchant of the present invention enables recess etching to be performed on the surface of the cobalt-containing metal layer embedded in a via or a trench formed in a semiconductor substrate in a single step without performing the oxidation and etching treatments separately, recess etching can be performed efficiently in a shorter time.

Herein, (A) organic acid will be sometimes referred to as "Component (A)," (B) nitrogen-containing heterocyclic compound as "Component (B)," (C) organic solvent as "Component (C)," and (D) water as "Component (D)".

The recess etchant of the present invention is used to perform recess etching on a surface of a cobalt-containing metal layer embedded in a via or a trench formed in a semiconductor substrate. According to the present invention, the cobalt-containing metal layer as the target of recess etching is a metal layer that contains cobalt. The cobalt content in the cobalt-containing metal layer is preferably 50 mass% or more, more preferably 70 mass% or more, still more preferably 90 mass% or more, yet still more preferably 95 mass% or more, and even 99 mass% or more. The cobalt-containing metal layer may contain a component other than cobalt, for example, other metal component, as long as it is in the range of less than 50 mass%.

In general, cobalt is known to have crystalline regions with various crystal orientations and grain sizes, and amorphous regions and gaps in the grain boundaries. Due to this, it is assumed that there are two types of partial corrosions in the cobalt-containing metal layer embedded in the via or the trench formed in the semiconductor substrate: namely, corrosion caused by the oxidation of cobalt over time (aging) and galvanic corrosion (Co -- -> Co²⁺ + 2e⁻) caused by the difference in corrosion potential between crystal orientations.

Cobalt in the amorphous regions and in the vicinity of the gaps is easily oxidized by aging, and the oxidized cobalt is quickly etched by acid-based chemicals. If there is a difference in corrosion potential between crystal orientations, galvanic corrosion is likely to occur in a certain crystal orientation and chemical corrosion is likely to progress locally.

In addition, it is difficult to obtain a smooth etched surface, especially in a fine wiring pattern, because the grain size tends to become small and the proportion of grain boundaries increases.

Therefore, it is necessary to suppress the partial corrosion of cobalt in the cobalt-containing metal layer in order to form a smooth etched surface on the cobalt-containing metal layer embedded in the via or the trench formed in the semiconductor substrate.

As a result of examining components that may have an effect of suppressing such partial corrosion, the present inventors have found that by using either or both of Component (B) and Component (C) in addition to Component (A) that has an etching effect, it is possible to perform recess etching on a surface of a cobalt-containing metal layer embedded in a via or a trench formed in a semiconductor substrate in a single step while suppressing partial corrosion of the cobalt using a single liquid. According to a preferred embodiment of the present invention, an etched surface with excellent smoothness can be obtained by suppressing the partial corrosion of cobalt as described above.

Component (B) has an anticorrosive effect on cobalt. It is assumed that the adsorption of Component (B) on the surface of the cobalt-containing metal layer shifts the corrosion potentials of all crystal orientations to the noble direction, which reduces the difference in corrosion potential between the crystal orientations, thereby presumably suppressing galvanic corrosion.

When compared to water, Component (C) has a destabilizing effect on cobalt ions (Co²⁺) produced by galvanic corrosion. Therefore, Component (C) is assumed to have an effect of reducing galvanic corrosion of cobalt. The etching of cobalt occurs through oxidation and dissolution represented by the following formulae, but Component (C) destabilizes the cobalt ion (Co²⁺) and slows down the dissolution of cobalt oxide. This allows slow etching of cobalt oxide caused by aging and thus suppresses partial corrosion of cobalt. In addition, organic solvents are generally more hydrophobic than water, and thus have higher dissolved oxygen concentrations than water. Therefore, the oxidation rate of cobalt is higher due to the effect of Component (C). In other words, the etching rate of cobalt is considered to be balanced by Component (C) because the oxidation rate becomes higher but the dissolution rate becomes lower, and it is assumed that the etching rate of cobalt is not significantly damaged by Component (C).

2Co + O₂ (dissolve oxygen) → 2CoO (oxidation)

CoO + 2acid → Co(acid⁻ H⁺)₂ + H₂O (dissolution)

Based on the above theory, it is possible to derive a recess etchant that is suitable not only for cobalt-containing metal layers but also for other metal layers. However, the above theory is based on speculation of the mechanism of how recess etching is controlled, and the present invention is in no way bound by the above theory.

As mentioned above, Component (B) and Component (C) are each considered to have an effect of suppressing partial corrosion of cobalt. In the present invention, only one of Component (B) and Component (C) may be used, or both components (B) and (C) may be used. According to one embodiment of the invention, it is preferable to use both of Component (B) and Component (C). By using both of Component (B) and Component (C), partial corrosion of cobalt can be suppressed more effectively, and a smoother etched surface may be obtained.

Hereinafter, each component will be described.

### (A) Organic acid (Component (A))

As mentioned above, in the recess etchant of the present invention, Component (A) has an etching effect on a cobalt-containing metal layer.

The organic acid used as Component (A) is not particularly limited as long as it is an organic compound that has a carboxyl group. Examples of Component (A) include aliphatic carboxylic acids, aromatic carboxylic acids, and amino acids. Among them, aliphatic carboxylic acids and aromatic carboxylic acids are preferable. More preferably, it is one or more selected from the group consisting of aliphatic carboxylic acids with 1-12 carbon atoms and aromatic carboxylic acids with 6-16 carbon atoms.

Examples of the aliphatic carboxylic acids include formic acid, acetic acid, propionic acid, lactic acid, glycolic acid, diglycolic acid, pyruvic acid, oxaloacetic acid, oxalic acid, malonic acid, butyric acid, hydroxybutyric acid, tartaric acid, succinic acid, malic acid, maleic acid, fumaric acid, valeric acid, glutaric acid, itaconic acid, adipic acid, caproic acid, citric acid, propane tricarboxylic acid, trans-aconitic acid, enanthic acid, caprylic acid, nonanoic acid, capric acid, lauric acid, myristic acid, palmitic acid, sorbic acid, iminodiacetic acid, ethylenediamine tetraacetic acid, diethylenetriamine pentaacetic acid, triethylenetetramine hexaacetic acid, and diaminocyclohexane tetraacetic acid.

One, or two or more of them can be used in combination.

Among them, acetic acid, citric acid, and combinations thereof are favorable as the aliphatic carboxylic acid.

Examples of the aromatic carboxylic acids include benzoic acid, phthalic acid, isophthalic acid, terephthalic acid, mandelic acid, 2-methylbenzoic acid, 3-methylbenzoic acid, 4-methylbenzoic acid, 2-ethylbenzoic acid, 3-ethylbenzoic acid, 4-ethylbenzoic acid, salicylic acid, 3-hydroxybenzoic acid, 4-hydroxybenzoic acid, 2-chlorobenzoic acid, 3-chlorobenzoic acid, 4-chlorobenzoic acid, 2-fluorobenzoic acid, 3-fluorobenzoic acid, 4-fluorobenzoic acid, 2-cyanobenzoic acid, 3-cyanobenzoic acid, 4-cyanobenzoic acid, 2-nitrobenzoic acid, 3-nitrobenzoic acid, 4-nitrobenzoic acid, 2,3-dimethylbenzoic acid, 3,4-dimethylbenzoic acid, 3,5-dimethylbenzoic acid, 2,5-dimethylbenzoic acid, 2,6-dimethylbenzoic acid, 2-hydroxy-3-methylbenzoic acid, 2-hydroxy-4-methylbenzoic acid, 2-hydroxy-5-methylbenzoic acid, 2-hydroxy-6-methylbenzoic acid, 3-hydroxy-2-methylbenzoic acid, 3-hydroxy-4-methylbenzoic acid, 3-hydroxy-5-methylbenzoic acid, 3-hydroxy-6-methylbenzoic acid, 4-hydroxy-2-methylbenzoic acid, 4-hydroxy-3-methylbenzoic acid, 2-methoxybenzoic acid, 3-methoxybenzoic acid, 4-methoxybenzoic acid, 2,3-dihydroxybenzoic acid, 2,4-dihydroxybenzoic acid, 2,5-dihydroxybenzoic acid, 2,6-dihydroxybenzoic acid, 3,4-dihydroxybenzoic acid, 3,5-dihydroxybenzoic acid, 3,6-dihydroxybenzoic acid, 2,4,5-trimethylbenzoic acid, 2,4,6-trimethylbenzoic acid, 1-naphthalenecarboxylic acid, 2-naphthalenecarboxylic acid, 1-hydroxy-2-naphthalenecarboxylic acid, 6-hydroxy-1-naphthalenecarboxylic acid, 6-hydroxy-2-naphthalenecarboxylic acid, 2-hydroxy-1-naphthalenecarboxylic acid, 3-hydroxy-2-naphthalenecarboxylic acid, 1,4-dihydroxy-2-naphthalenecarboxylic acid, 1-anthracenecarboxylic acid, 2-anthracenecarboxylic acid, 9-anthracenecarboxylic acid, gallic acid, mellitic acid, and cinnamic acid.

One, or two or more of them can be used in combination.

Among them, benzoic acid, phthalic acid, isophthalic acid, terephthalic acid, 3-hydroxybenzoic acid, 4-hydroxybenzoic acid, and combinations thereof are preferred as the aromatic carboxylic acid.

As Component (A), only either aliphatic carboxylic acid or aromatic carboxylic acid may be used, or both aliphatic carboxylic acid and aromatic carboxylic acid may be used.

The content of Component (A) is preferably 0.001-10 mass%, more preferably 0.01-3 mass%, still more preferably 0.03-1 mass%, and particularly preferably 0.06-0.5 mass%, based on the mass of the recess etchant.

The upper and lower limits of numerical ranges indicated herein may be combined as appropriate, and the disclosure is deemed to include the numerical ranges obtained thereby as well.

### (B) Nitrogen-containing heterocyclic compound (Component (B))

In the recess etchant of the present invention, Component (B) acts to suppress partial corrosion of cobalt contained in the cobalt-containing metal layer.

The nitrogen-containing heterocyclic compound used as Component (B) is not particularly limited as long as it is a compound that contains nitrogen atoms as heteroatoms constituting the ring. For example, it may be a triazole, tetrazole, thiazole, pyrazole, imidazole, or nucleobase.

Examples of the triazoles include 1,2,3-triazole, 1,2,4-triazole, 3,5-dimethyl-1,2,4-triazole, 3-amino-1,2,4-triazole, 4-amino-1,2,4-triazole, 3-mercapto-4-methyl-4H-1,2,4-triazole, 1H-benzotriazole, 1H-benzotriazole-1-methanol, 4-methyl-1H-benzotriazole, 2-(2-hydroxy-5-methylphenyl)benzotriazole, 5-methyl-1H-benzotriazole, 3-chloro-1H-benzotriazole, 5-chloro-1H-benzotriazole, methyl 1,2,4-triazole-3-carboxylate, 2-(5-chloro-2-benzotriazolyl)-6-tert-butyl-p-cresol, and 3-amino-1H-triazole.

Examples of the tetrazoles include 1H-tetrazole, 5-methyl-1H-tetrazole, 5-phenyl-1H-tetrazole, 5-mercapto-1-metllyl-1H-tetrazole, 5-mercapto-1-phenyl-1H-tetrazole, 5-benzyl-1H-tetrazole, and 5-amino-IH-tetrazole.

Examples of the thiazoles include 1,3-thiazole and 4-methylthiazole.

Examples of the pyrazoles include pyrazole and 3,5-dimethylpyrazole.

Examples of the imidazoles include imidazole, 2-methylimidazole, 1-propylimidazole, 1-isopropylimidazole, 2-undecylimidazole, 2-phenylimidazole, benzimidazole, 2-methylbenzimidazole, and 2-hydroxybenzimidazole.

Examples of the nucleobases include purine, adenine, guanine, pyrimidine, uracil, thymine, and cytosine. One, or two or more of them can be used in combination.

Among them, triazoles are preferred, which are preferably 1,2,4-triazole, 1H-benzotriazole, and 5-methyl-1H-benzotriazole.

The content of Component (B) is preferably 0.001-5 mass%, more preferably 0.01-1 mass%, still more preferably 0.025-0.4 mass%, and particularly preferably 0.025-0.1 mass%, based on the mass of the recess etchant.

### (C) Organic solvent (Component (C))

In the recess etchant of the present invention, Component (C) acts to suppress partial corrosion of cobalt contained in the cobalt-containing metal layer.

Component (C) is, for example, preferably an organic solvent with an HLB (Hydrophile-Lipophile Balance) value of 3-15. The HLB value is more preferably 3-13, still more preferably 3-11, and even more preferably 3-9. The lower the HLB value and thus the higher the hydrophobicity, the more effective the destabilization of cobalt ions (Co²⁺) and the control of etching will be.

Specifically, examples of Component (C) include methanol, ethanol, 1-propanol, 2-propanol (isopropyl alcohol), 1-butanol, 2-butanol, 2-methyl-1-propanol, 2-methyl-2-propanol, cyclohexanol, ethylene glycol, propylene glycol, 1,2-butanediol, 1,3-butanediol, 1,4-butanediol, 2,3-butanediol, 1,2-pentanediol, 1,5-pentanediol, 2,4-pentanediol, diethylene glycol, dipropylene glycol, dibutylene glycol, triethylene glycol, tripropylene glycol, 1,2-hexanediol, 1,6-hexanediol, neopentyl glycol, glycerol, dimethyl sulfoxide, dimethyl formamide, dimethyl acetamide, acetone, methyl ethyl ketone, N-methylpyrrolidone, methyl formate, ethyl formate, 1-propyl formate, 2-propyl formate, methyl acetate, ethyl acetate, 1-propyl acetate, 2-propyl acetate, methyl propionate, ethyl propionate, 1-propyl propionate, 2-propyl propionate, dimethyl ether, methyl ethyl ether, diethyl ether, tetrahydrofuran, ethylene glycol monomethyl ether, ethylene glycol monoethyl ether, ethylene glycol mono-1-propyl ether, ethylene glycol mono-2-propyl ether, ethylene glycol monophenyl ether, propylene glycol monomethyl ether, propylene glycol monoethyl ether, propylene glycol mono-1-propyl ether, propylene glycol mono-2-propyl ether, propylene glycol monophenyl ether, butylene glycol monomethyl ether, butylene glycol monoethyl ether, butylene glycol mono-1-propyl ether, butylene glycol mono-2-propyl ether, butylene glycol monophenyl ether, ethylene glycol dimethyl ether, ethylene glycol ethyl methyl ether, ethylene glycol diethyl ether, propylene glycol dimethyl ether, propylene glycol ethyl methyl ether, propylene glycol diethyl ether, diethylene glycol monomethyl ether, diethylene glycol monoethyl ether, diethylene glycol mono-1-propyl ether, diethylene glycol mono-2-propyl ether, diethylene glycol monophenyl ether, dipropylene glycol dimethyl ether, dipropylene glycol ethyl methyl ether, dipropylene glycol diethyl ether, triethylene glycol monomethyl ether, triethylene glycol monoethyl ether, triethylene glycol mono-1-propyl ether, triethylene glycol mono-2-propyl ether, triethylene glycol monophenyl ether, tripropylene glycol dimethyl ether, tripropylene glycol ethyl methyl ether, and tripropylene glycol diethyl ether. One, or two or more of them can be used in combination.

Among them, 1-propanol, 2-propanol, 1-butanol, 2-butanol, 2-methyl-1-propanol, 2-methyl-2-propanol, cyclohexanol, ethylene glycol, propylene glycol, 1,2-butanediol, 1,3-butanediol, 1,4-butanediol, 2,3-butanediol, 1,2-pentanediol, 1,5-pentanediol, 2,4-pentanediol, diethylene glycol, dipropylene glycol, dibutylene glycol, triethylene glycol, tripropylene glycol, 1,2-hexanediol, 1,6-hexanediol, neopentyl glycol, glycerol, dimethyl sulfoxide, dimethylformamide, dimethylacetamide, acetone, methyl ethyl ketone, and combinations thereof are preferred.

The content of Component (C) is preferably 1-99 mass, more preferably 5-80 mass%, still more preferably 10-60 mass%, and particularly preferably 30-50 mass%, based on the mass of the recess etchant.

### (D) Water (Component (D))

The recess etchant of the present invention contains water as a diluent. Water is preferably water from which metal ions, organic impurities, and particle particles have been removed by distillation, ion exchange treatment, filtration treatment, or any adsorption treatment, and it is particularly preferably pure water or ultrapure water.

The content of Component (D) is the remaining portion of the recess etchant, which is preferably 1 mass% or more, more preferably in the range of 5-99.9 mass%, still more preferably 20-99 mass%, yet still more preferably 30-95 mass%, and particularly preferably 35-90 mass%, based on the mass of the recess etchant.

### (E) Other components

In addition to Component (A), Component (B), Component (C), and Component (D), the recess etchant of the present invention may contain additives such as an oxidant, reducing agent, surfactant, chelating agent, inorganic acid, and alkali which are generally used for etching cobalt-containing metal layers, as long as they do not interfere with the effect of the invention.

However, it is preferable that the recess etchant does not contain an oxidant, because the oxidant may cause the etching rate of cobalt to be significantly higher, making it difficult to control the amount of recess etching. Moreover, since sulfonium compounds may adsorb to the cobalt surface and affect the electrical characteristics of the semiconductor device, the recess etchant of the present invention preferably does not contain sulfonium compounds.

If the recess etchant contains an inorganic acid (for example, sulfuric acid, nitric acid, hydrochloric acid, phosphoric acid, sulfamic acid, etc.), the surface after the etching treatment may become rough and it may be difficult to obtain a smooth surface. Therefore, it is preferable that the content of inorganic acid is less than 0.1 mass% based on the mass of the recess etchant or it is preferable that the recess etchant substantially does not contain an inorganic acid. The content of the inorganic acid is preferably less than 0.1 mass%, more preferably less than 0.01 mass%, and particularly preferably less than 0.001 mass%, based on the mass of the etchant.

According to a preferred embodiment of the present invention, the total content of Component (A), Component (B), Component (C), and Component (D) is preferably 95 mass% or more, more preferably in the range of 96-100 mass%, still more preferably 97-100 mass%, yet still more preferably 98-100 mass%, and particularly preferably 99-100 mass%, based on the mass of the recess etchant.

While either or both of Component (B) and Component (C) can be used in the present invention, when both of Component (B) and Component (C) are used, the recess etchant of the present invention preferably contains 0.001-10 mass% of Component (A), 0.001-5 mass% of Component (B), 1-99 mass% of Component (C), and the remaining of Component (D). A more favorable recess etchant can be obtained by combining the above contents of Component (A), Component (B), and Component (C) in more favorable ranges.

When the etchant contains only Component (B) of Component (B) and Component (C), the preferred content of Component (B) is also the same as described above and remains the same. In this case, the recess etchant of the present invention preferably contains 0.001-10 mass% of Component (A), 0.01-1 mass% of Component (B), and 89-99.989 mass% of Component (D), more preferably contains 0.001-10 mass% of Component (A), 0.025-0.4 mass% of Component (B), and 89.6-99.974 mass% of Component (D), and still more preferably contains 0.001-10 mass% of Component (A), 0.025-0.1 mass% of Component (B), and 89.9-99.974 mass% of Component (D).

When the etchant contains only Component (C) of Component (B) and Component (C), the preferred content of Component (C) is also the same as described above and remains the same. In this case, the recess etchant of the present invention preferably contains 0.001-10 mass% of Component (A), 5-80 mass% of Component (C), and 10-94.999 mass% of Component (D), more preferably contains 0.001-10 mass% of Component (A), 10-60 mass% of Component (C), and 30-89.999 mass% of Component (D), and still more preferably contains 0.001-10 mass% of Component (A), 30-50 mass% of Component (C), and 40-69.999 mass% of Component (D).

In the present invention, the pH value of the recess etchant is not particularly limited, but it is preferably in the range of 1.0-6.0, more preferably 1.5-4.5, still more preferably 2.3-3.8, and particularly preferably 2.3-3.6.

The recess etchant of the present invention may be added with a pH adjuster as necessary to adjust the pH range. Examples of the pH adjuster include potassium hydroxide, lithium hydroxide, cesium hydroxide, triethylamine, ammonia, tetramethylammonium hydroxide, ethanolamine, and 1-amino-2-propanol. One or two or more kinds of pH adjusters can be used.

The recess etchant of the present invention can be prepared by stirring Components (A) to (D) and, if necessary, additional Component (E) to a homogeneous state. Note that some or all of water as Component (D) may be added later. A solution containing Components (A) to (C), a portion of Component (D), and, if necessary, additional Component (E) may be prepared and stored in advance, and then diluted with the remaining portion of Component (D) before use.

### 2. Recess etching method

A recess etching method according to the present invention is characterized by comprising a recess etching step in which the aforementioned recess etchant is brought into contact with a surface of a cobalt-containing metal layer embedded in a via or a trench formed in a semiconductor substrate to perform recess etching on the surface of the cobalt-containing metal layer.

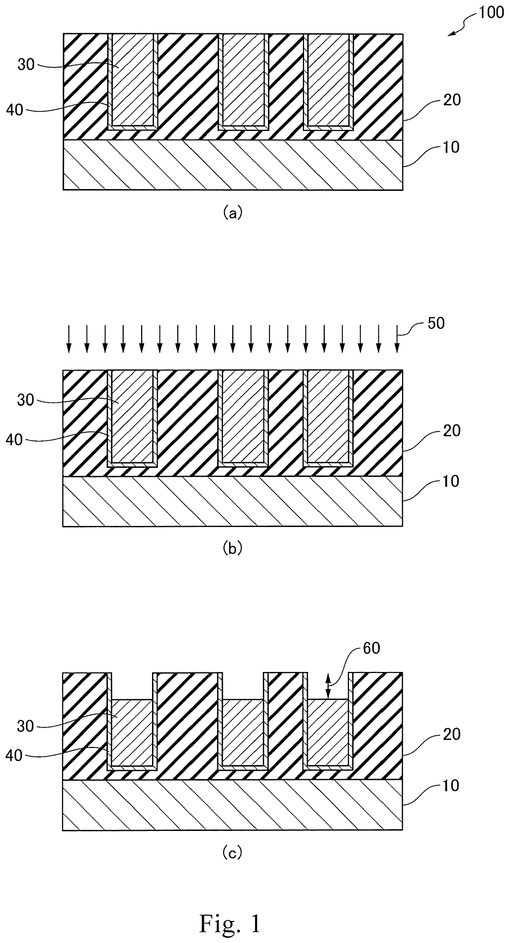

Figure 1 shows drawings for illustrating a recess etching method according to the present invention. In Figure 1, only a structure necessary to explain the steps of the recess etching method is schematically shown.

First, as shown in Figure 1(a), a via or a trench is formed in an interlayer dielectric 20 provided on a substrate 10 and a cobalt-containing metal layer 30 is embedded in this via or trench, thereby preparing a semiconductor substrate 100 having a wiring structure.

A barrier metal layer 40 such as a titanium layer, titanium nitride layer or the like may be formed on the inner wall of the via or the trench.

The semiconductor substrate 100 can be produced by a method commonly employed in the industry. For example, the semiconductor substrate 100 can be produced as follows.

First, the interlayer dielectric 20 is formed on the substrate 10.

Next, a via or a trench is formed in the interlayer dielectric 20 by dry etching or the like. Furthermore, the barrier metal layer 40 is formed on the inner wall of the via or the trench, if necessary.

Subsequently, the cobalt-containing metal layer 30 is formed to fill the via or the trench formed in the interlayer dielectric 20.

Finally, if necessary, CMP (chemical mechanical polishing) is performed to obtain a semiconductor substrate 100 with a smooth top.

Next, as shown in Figure 1(b), a recess etchant 50 is brought into contact with the surface of the cobalt-containing metal layer 30 exposed on the top of the semiconductor substrate 100.

According to the present invention, the method of bringing the recess etchant 50 into contact with the surface of the cobalt-containing metal layer 30 is not particularly limited. For example, a method of bringing the recess etchant into contact with the surface of the cobalt-containing metal layer by means of dropping (single-wafer spin treatment) or spraying, or a method of immersing the surface of the cobalt-containing metal layer in the recess etchant can be employed.

The temperature of the recess etchant upon bringing the recess etchant 50 into contact with the cobalt-containing metal layer 30 is not particularly limited, but it is, for example, 0-70°C, preferably 25-65°C, more preferably 25-60°C, and still more preferably 30-60°C. If the temperature of the recess etchant is 25°C or higher, the recess etching can be performed in a shorter time. At the same time, if the temperature is 60°C or below, changes in the liquid composition can be suppressed and treatment conditions can be kept constant.

The time for bringing the recess etchant 50 into contact with the cobalt-containing metal layer 30 (treatment time) is not particularly limited, but it is usually 15 seconds or longer and 10 minutes or shorter, more preferably 30 seconds or longer and 7.5 minutes or shorter, and still more preferably 30 seconds or longer and 5 minutes or shorter. The optimal treatment time may be selected according to the method of contact between the cobalt-containing metal layer and the recess etchant, the temperature of the recess etchant, and the like.

In the recess etching method of the present invention, the etching rate of the cobalt-containing metal layer is preferably 0.5-20 nm/min, more preferably 0.9-15 nm/min, still more preferably 0.9-10 nm/min, and particularly preferably 0.9-7.5 nm/min.

By bringing the recess etchant 50 into contact with the surface of the cobalt-containing metal layer 30 in the manner described above, recess etching can be performed on the surface of the cobalt-containing metal layer 30 as shown in Figure 1(c). The barrier metal layer 40 in the area where the recess etching is performed may be removed by etching separately in a step after the recess etching, or may be left as it is without conducting an etching step and proceed to the next step.

The preferred amount of recess etching performed on the cobalt-containing metal layer by the recess etching method of the present invention and the surface roughness of the recess-etched surface will be described in "3. Method for manufacturing surface-treated semiconductor substrate."

After the aforementioned recess etchant is brought into contact with the cobalt-containing metal layer to perform recess etching, the resultant may be cleaned as necessary with water, isopropyl alcohol, aqueous ammonia solution, aqueous tetramethylammonium hydroxide solution, or the like. In addition, an anti-rust treatment with an aqueous solution containing an anti-rust agent may also be performed.

### 3. Method for manufacturing surface-treated semiconductor substrate

A method for manufacturing a surface-treated semiconductor substrate according to the present invention is characterized by comprising a recess etching step in which the aforementioned recess etchant is brought into contact with a surface of a cobalt-containing metal layer embedded in a via or a trench formed in a semiconductor substrate to perform recess etching on the surface of the cobalt-containing metal layer. As used herein, a "surface-treated semiconductor substrate" refers to a semiconductor substrate which is obtained by bringing the aforementioned recess etchant into contact with a surface of a cobalt-containing metal layer embedded in a via or a trench formed in the semiconductor substrate to perform recess etching on the surface of the cobalt-containing metal layer.

The method of bringing the recess etchant into contact with the surface of the cobalt-containing metal layer, the temperature of the recess etchant upon contact, and the contact time are as described in "2. Recess etching method" above. Also, after the recess etching step, cleaning may be performed as appropriate, as described in "2. Recess etching method" above.

According to the present invention, a surface-treated semiconductor substrate can be manufactured, which has recess etching performed on a surface of a cobalt-containing metal layer embedded in a via or a trench formed in the semiconductor substrate. In the semiconductor substrate having a wiring structure including the cobalt-containing metal layer manufactured by the present invention, a wiring circuit can be constructed by further stacking a metal wiring layer containing cobalt or copper in a step after the recess etching described above.

The amount of recess etching performed on the cobalt-containing metal layer (specifically, the depth of the recess formed by performing recess etching on the cobalt-containing metal layer) by the recess etching according to the present invention is not particularly limited, but from the viewpoint of preventing a short circuit in the metal wiring due to misalignment upon forming a metal wiring pattern, it is preferably 2.5-20 nm, more preferably 5-15 nm, and still more preferably 7.5-12.5 nm.

In addition, the surface roughness (Ra) of the recess-etched surface of the cobalt-containing metal layer resulting from the recess etching according to the present invention is preferably 8.5 nm or less, more preferably 5 nm or less, still more preferably 3 nm or less, yet still more preferably 2.5 nm or less, and particularly preferably 1 nm or less. In the present invention, the surface roughness (Ra) of the recess-etched surface refers to the roughness correction value for the cobalt-containing metal layer. The roughness correction value can be determined by the method described in the examples below.

### 4. Method for manufacturing semiconductor device

A method for manufacturing a semiconductor device according to the present invention is characterized by comprising:
a recess etching step in which the aforementioned recess etchant is brought into contact with a surface of a cobalt-containing metal layer embedded in a via or a trench formed in a semiconductor substrate to perform recess etching on the surface of the cobalt-containing metal layer;
a step of stacking a metal wiring layer on the surface of the cobalt-containing metal layer in the surface-treated semiconductor substrate obtained in the above step to obtain a semiconductor substrate having a wiring circuit constructed thereon; and
a step of cutting the semiconductor substrate having the wiring circuit constructed thereon obtained in the above step into a predetermined shape, thereby obtaining a semiconductor device.

According to the present invention, since recess etching can be performed uniformly on the metal wiring in the recess etching step, a short circuit in the metal wiring is unlikely to occur and a semiconductor device with excellent electrical characteristics can be obtained.

A metal wiring layer that can be stacked on the surface of the cobalt-containing metal layer is not particularly limited as long as it can be electrically connected to the cobalt-containing metal layer, such as those containing cobalt or copper. The number of metal wiring layer that can be stacked on the surface of the cobalt-containing metal layer may be one, two, or more.

### EXAMPLES

Hereinafter, the present invention will be described in more detail by means of examples and comparative examples, but the present invention is in no way limited to these examples.

### Examples 1-18

### (1) Preparation of recess etchants

Recess etchants were prepared by mixing and stirring the components in the composition ratios shown in Table 1 to a homogeneous state.

### (2) Recess etching of cobalt-containing metal layer

As a sample used for evaluation of the recess etchant, "Wafer with CVD cobalt film" manufactured by Philtech Inc., which had a cobalt metal layer (thickness: 90 nm) on a surface of a substrate, was used.

As a pretreatment, an aqueous acetic acid solution (0.01 mass%) was brought into contact with the surface of the evaluation sample at 30°C for 5 minutes to remove the oxide on the surface of the cobalt metal layer.

Next, an etching treatment was performed by immersing the surface of the pretreated evaluation sample in the recess etchant prepared in (1) above at 50°C or 20°C (the treatment temperature in each example is shown in Table 1) for the time indicated in Table 1 (the time required for etching a cobalt metal layer 50 nm deep, calculated from the etching rate of the cobalt-containing metal layer described below).

### (3) Calculation of roughness value

The evaluation sample that underwent the etching treatment was subjected to FIB fabrication (instrument: Helios G4 UX manufactured by Thermo Fisher Scientific Inc.) to obtain a post-etch evaluation sample with a smooth cross-section.

Next, the cross-section of the obtained evaluation sample was observed with SEM (instrument: Helios G4 UX manufactured by Thermo Fisher Scientific Inc.), and XY coordinates of the roughness in the SEM image was converted to Excel data using Image J (developed by Wayne Rasband, National Institutes of Health, USA).

The roughness value of the cobalt-containing metal layer was obtained by calculating the standard deviation of the Y-coordinate using the Excel data.

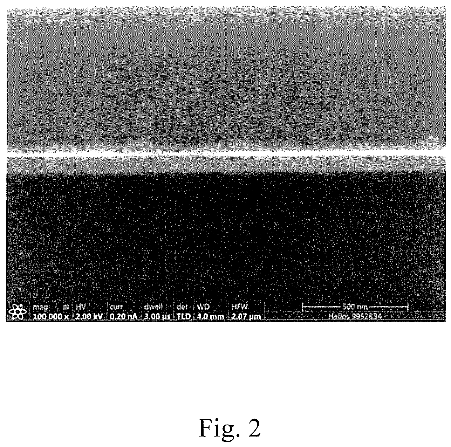

As one example of the cross-section of the evaluation sample after the etching treatment, a cross-sectional SEM image of the post-etch evaluation sample of Example 11 (magnification x100,000, an area 2,070 nm long in the horizontal direction) is shown in Figure 2.

### <Etching rate of cobalt-containing metal layer (Co E.R.)>

The etching rate of the cobalt-containing metal layer was calculated by defining the etching rate as the difference in the thickness of the cobalt metal layer before and after the etching treatment divided by the treatment time (5 minutes). An etching rate of 0.5 (nm/min) or more was considered acceptable.

### <Roughness correction value for cobalt-containing metal layer (Co roughness correction value)>

The roughness value of the cobalt-containing metal layer after the etching treatment was obtained by the method described in "(3) Calculation of roughness value" above. In one cross-section obtained by FIB fabrication, SEM images were acquired at four different locations, and the average of the four roughness values obtained from each SEM image was defined as "roughness value A".

The roughness value of the cobalt-containing metal layer was calculated according to the method described above after 5 minutes of contact with an aqueous acetic acid solution (0.01 mass%) at 30°C, without immersion in the recess etchant (roughness value B; 6.7 nm).

The value obtained by subtracting the roughness value B from the roughness value A was defined as the "roughness correction value," and a roughness correction value of 8.5 (nm) or less was considered acceptable.

### Comparative examples 1-9

Recess etchants were prepared in the same manner as in the examples and etching treatment was performed on cobalt-containing metal layers using evaluation samples except that the composition ratios and treatment time were as indicated in Table 2. Etching rates and roughness correction values for the cobalt-containing metal layers were calculated in the same manner as in the examples.

Results are shown in Tables 1 and 2.

**[Table 1]**

| Example | Composition | | | | | | | | pH | Treatment temperature (°C) | Treatment time (min) | Evaluation items | |
|---|---|---|---|---|---|---|---|---|---|---|---|---|---|
| | Component (A) | Mass% | Component (B) | Mass% | Component (C) | Mass% | Component (D) | Mass% | | | | Co E.R. (nm/min) | Co roughness correction value (nm) |
| 1 | Phthalic acid | 0.08 | | | Propylene glycol | 50 | Water | 49.92 | 3.1 | 50 | 26 | 1.9 | 7.7 |
| 2 | Phthalic acid | 0.08 | | | Neopentyl glycol | 50 | Water | 49.92 | 3.1 | 50 | 29 | 1.7 | 4.6 |
| 3 | Phthalic acid | 0.08 | | | \| Glycerol | 30 | Water | 69.92 | 2.7 | 50 | 22 | 2.2 | 3.0 |
| 4 | Phthalic acid | 0.08 | | | DMSO | 30 | Water | 69.92 | 3.2 | 50 | 7 | 7.5 | 6.2 |
| 5 | Phthalic acid | 0.08 | | | DMAC | 30 | Water | 69.92 | 3.3 | 50 | 12 | 4.2 | 3.4 |
| 6 | 4-Hydroxybenzoic acid | 0.07 | | | Propylene glycol | 50 | Water | 49.93 | 3.8 | 50 | 42 | 1.2 | 7.6 |
| 7 | Citric acid | 0.10 | | | Propylene glycol | 50 | Water | 49.90 | 3.5 | 50 | 18 | 2.8 | 5.4 |
| 8 | Benzoic acid | 0.06 | | | IPA | 10 | Water | 89.94 | 3.4 | 50 | 17 | 2.9 | 5.7 |
| 9 | Acetic acid | 0.03 | | | IPA | 10 | Water | 89.97 | 3.6 | 50 | 9 | 5.7 | 8.1 |
| 10 | Phthalic acid | 1.110 | | | \| Dipropylene glycol | 30 | Water | 69.00 | 2.3 | 20 | 56 | 0.9 | 3.0 |
| 11 | Phthalic acid | 0.08 | 5-Methyl-1H-benzotriazole | 0.025 | | | Water | 99.90 | 2.7 | 50 | 25 | 2.0 | 4.3 |
| 12 | Benzoic acid | 0.06 | 5-Methyl-1H-benzotriazole | 0.025 | | | Water | 99.92 | 3.3 | 50 | 46 | 1.1 | 5.6 |
| 13 | Phthalic acid | 0.08 | 1H-benzotriazol e | 0.1 | | | Water | 99.82 | 2.7 | 50 | 24 | 2.1 | 2.7 |
| 14 | Phthalic acid | 0.08 | 1.2.4-Triazole | 0.025 | | | Water | 99.90 | 3.0 | 50 | | 4.5 | 4.6 |
| 15 | Phthalic acid | 0.50 | 5-Methyl-1H-benzotriazole | 0.4 | | | Water | 99.10 | 23 | 50 | 50 | 1.0 | 4.3 |
| 16 | Phthalic acid | 0.08 | 5-Methyl-1H-benzotriazole | 0.025 | IPA | 10 | Water | 89.90 | 2.8 | 50 | 23 | 2.1 | 2.4 |
| 17 | Phthalic acid | 0.08 | 5-Methyl-1H-benzotriazole | 0.05 | Propylene glycol | 50 | Water | 49.87 | 3.1 | 50 | 35 | 1.4 | 0.7 |
| 18 | Phthalic acid | 0.08 | 5-Methyl-1H-benzotriazole | 0.025 | Neopentyl glycol | 60 | Water | 39.90 | 3.1 | 50 | 23 | 2.1 | <0.1 |

| | | | | | | | | | | | | | |
|---|---|---|---|---|---|---|---|---|---|---|---|---|---|
| DMSO: Dimethyl sulfoxide DMAC: Dimethyl acetamide IPA: Isopropyl alcohol | | | | | | | | | | | | | |

**Table 2**

| Comparative example | Composition | | | | | | | | pH | Treatment temperature (°C) | Treatment time (min) | Evaluation items | |
|---|---|---|---|---|---|---|---|---|---|---|---|---|---|
| | Component (A) | Mass% | Component (B) | Mass% | Component (C) | Mass% | Component (D) | Mass% | | | | Co E.R. (nm/min) | Co roughness correction value (nm) |
| 1 | Phthalic acid | 0.08 | | | | | Water | 99.92 | 2.7 | 50 | 9 | 5.4 | 10.0 |
| 2 | Benzoic acid | 0.06 | | | | | Water | 99.94 | 3.3 | 50 | 23 | 2.2 | 16.4 |
| 3 | Acetic acid | 0.03 | | | | | Water | 99.97 | 3.6 | 50 | 15 | 3.4 | 9.2 |
| 4 | Hydrochloric acid | 0.02 | | | | | Water | 99.98 | 2.4 | 50 | 4 | 12.7 | 17.6 |
| 5 | Hydrofluoric acid | 0.01 | | | | | Water | 99.99 | 2.9 | 50 | 5 | 9.2 | 18.3 |
| 6 | Hydrofluoric acid | 0.01 | | | IPA | 10 | Water | 89.99 | 2.9 | 50 | 8 | 6.5 | 12.8 |
| 7 | Hydrofluoric acid | 0.01 | 5-Methyl-1H-benzotriazole | 0.025 | | | Water | 99.97 | 2.9 | 50 | 9 | 5.5 | 21.8 |
| 8 | Hydrofluoric acid | 0.01 | 5-Methyl-1H-benzotriazole | 0.025 | IPA | 10 | Water | 89.97 | 2.9 | 50 | 12 | 4.0 | 14.1 |
| 9 | Hydrofluoric acid | 0.01 | 3-Methyl-1H-benzotriazolc | 0.025 | Dipropylcne glycol | 50 | Water | 49.97 | 3.3 | 50 | 12 | 4.2 | 14.0 |

| | | | | | | | | | | | | | |
|---|---|---|---|---|---|---|---|---|---|---|---|---|---|
| IPA: Isopropyl alcohol | | | | | | | | | | | | | |

In the table, hydrofluoric acid is expressed in mass% in terms of hydrogen fluoride.

As shown in Table 1, by treating a cobalt-containing metal layer with the recess etchant of the present invention, the roughness correction value for the cobalt-containing metal layer can be kept low and a smooth etched surface can be obtained by a single-step treatment (Examples 1-18).

On the other hand, as shown in Table 2, when only an organic acid was used without a nitrogen-containing heterocyclic compound and organic solvent (Comparative examples 1-3), or when only an inorganic acid was used (Comparative examples 4 and 5), or when an inorganic acid was combined with either or both nitrogen-containing heterocyclic compound and organic solvent (Comparative examples 6-9), the roughness correction values for the cobalt-containing metal layers became significantly higher.

As can be appreciated from the above results, a cobalt-containing metal layer with a smooth etched surface can be obtained more efficiently in a shorter time by a single-step treatment by using the recess etchant of the present invention. Since the recess etchant of the present invention is excellent in obtaining a smooth etched surface in the treatment of a cobalt-containing metal layer, it can be used suitably as a recess etchant where the smoothness of the etched surface is crucial.

### DESCRIPTION OF REFERENCE NUMERALS

- 10: Substrate
- 20: Interlayer dielectric
- 30: Cobalt-containing metal layer
- 40: Barrier metal layer
- 50: Recess etchant
- 60: Amount of recess etching
- 100: Semiconductor substrate

## Claims

1. A recess etchant for performing recess etching on a surface of a cobalt-containing metal layer embedded in a via or a trench formed in a semiconductor substrate, the recess etchant comprising the following components:
(A) organic acid; either or both of (B) nitrogen-containing heterocyclic compound and (C) organic solvent; and (D) water.

2. The recess etchant of claim 1, comprising the following components: (A) organic acid; (B) nitrogen-containing heterocyclic compound; (C) organic solvent; and (D) water.

3. The recess etchant of claim 1 or 2, wherein Component (A) above is one or more selected from the group consisting of aliphatic carboxylic acids with 1-12 carbon atoms and aromatic carboxylic acids with 6-16 carbon atoms.

4. The recess etchant of claim 3, wherein the aromatic carboxylic acid is one or more selected from the group consisting of benzoic acid, phthalic acid, isophthalic acid, terephthalic acid, 3-hydroxybenzoic acid, and 4-hydroxybenzoic acid.

5. The recess etchant of claim 3 or 4, wherein the aliphatic carboxylic acid is one or more selected from the group consisting of acetic acid and citric acid.

6. The recess etchant of any one of claims 1 to 5, wherein Component (B) above is one or more selected from the group consisting of triazoles, tetrazoles, thiazoles, pyrazoles, imidazoles, and nucleobases.

7. The recess etchant of any one of claims 1 to 6, wherein Component (B) above is one or more selected from the group consisting of 1,2,3-triazole, 1,2,4-triazole, 3,5-dimethyl-1,2,4-triazole, 3-amino-1,2,4-triazole, 4-amino-1,2,4-triazole, 3-mercapto-4-methyl-4H-1,2,4-triazole, 1H-benzotriazole, 1H-benzotriazole-1-methanol, 4-methyl-1H-benzotriazole, 2-(2-hydroxy-5-methylphenyl)benzotriazole, 5-methyl-1H-benzotriazole, 3-chloro-1H-benzotriazole, 5-chloro-1H-benzotriazole, methyl 1,2,4-triazole-3-carboxylate, 2-(5-chloro-2-benzotriazolyl)-6-tert-butyl-p-cresol, and 3-amino-1H-triazole.

8. The recess etchant of any one of claims 1 to 7, wherein Component (C) above is one or more selected from the group consisting of organic solvents having an HLB (Hydrophile-Lipophile Balance) value of 3-15.

9. The recess etchant of any one of claims 1 to 8, wherein Component (C) above is one or more selected from the group consisting of 1-propanol, 2-propanol, 1-butanol, 2-butanol, 2-methyl-1-propanol, 2-methyl-2-propanol, cyclohexanol, ethylene glycol, propylene glycol, 1,2-butanediol, 1,3-butanediol, 1,4-butanediol, 2,3-butanediol, 1,2-pentanediol, 1,5-pentanediol, 2,4-pentanediol, diethylene glycol, dipropylene glycol, dibutylene glycol, triethylene glycol, tripropylene glycol, 1,2-hexanediol, 1,6-hexanediol, neopentyl glycol, glycerol, dimethyl sulfoxide, dimethylformamide, dimethylacetamide, acetone, and methyl ethyl ketone.

10. The recess etchant of any one of claims 1 to 9, comprising 0.001-10 mass% of (A) organic acid, 0.001-5 mass% of (B) nitrogen-containing heterocyclic compound, and 1-99 mass% of (C) organic solvent.

11. The recess etchant of any one of claims 1 to 10, wherein the pH value is in the range from 1.0 to 6.0.

12. A recess etching method comprising a recess etching step in which the recess etchant of any one of claims 1 to 11 is brought into contact with a surface of a cobalt-containing metal layer embedded in a via or a trench formed in a semiconductor substrate to perform recess etching on the surface of the cobalt-containing metal layer.

13. A method for manufacturing a surface-treated semiconductor substrate, the method comprising a recess etching step in which the recess etchant of any one of claims 1 to 11 is brought into contact with a surface of a cobalt-containing metal layer embedded in a via or a trench formed in a semiconductor substrate to perform recess etching on the surface of the cobalt-containing metal layer.

14. A method for manufacturing a semiconductor device, comprising:
a recess etching step in which the recess etchant of any one of claims 1 to 11 is brought into contact with a surface of a cobalt-containing metal layer embedded in a via or a trench formed in a semiconductor substrate to perform recess etching on the surface of the cobalt-containing metal layer;
a step of stacking a metal wiring layer on the surface of the cobalt-containing metal layer in the surface-treated semiconductor substrate obtained in the above step to obtain a semiconductor substrate having a wiring circuit constructed thereon; and
a step of cutting the semiconductor substrate having the wiring circuit constructed thereon obtained in the above step into a predetermined shape, thereby obtaining a semiconductor device.
